Europäisches Patentamt

European Patent Office

Office européen des brevets

(11) Publication number : **0 585 050 A2**

(19)

# (12) EUROPEAN PATENT APPLICATION

(21) Application number : 93306545.0

(22) Date of filing : 19.08.93

(51) Int. Cl.⁵ : **H03L 7/23**

(30) Priority : **24.08.92 JP 224445/92**

(43) Date of publication of application :
**02.03.94 Bulletin 94/09**

(84) Designated Contracting States :
**DE FR NL**

(71) Applicant : **Oki Electric Industry Co., Ltd.**
**7-12, Toranomon 1-chome Minato-ku**
**Tokyo (JP)**

(72) Inventor : **Tsukagoshi, Shosaku, c/o Oki**
**Electric Ind. Co. Ltd**
**7-12, Toranomon 1-chome**
**Minato-ku, Tokyo (JP)**

(74) Representative : **Read, Matthew Charles et al**
**Venner Shipley & Co. 20 Little Britain**
**London EC1A 7DH (GB)**

(54) **Multi-mode frequency synthesiser with reduced jitter.**

(57)   A frequency synthesizer has two cascaded phase-locked loops (48,50), each of which receives an input signal and a feedback signal and generates an output signal. The output of the first phase-locked loop (48) is supplied as input to the second phase-locked loop (50). The output of the second phase-locked loop is supplied as feedback to both the first and second phase-locked loops. The output frequency of the second phase-locked loop is selected by means of programmable frequency dividers (28,30,38,40) inserted in the input and feedback lines of the first phase-locked loop.

FIG. 3

## BACKGROUND OF THE INVENTION

This invention relates to a frequency synthesizer, more specifically to a frequency synthesizer that receives an input clock signal and generates a stable output clock signal at any of several selectable frequencies.

One application of such a frequency synthesizer is in a television receiver that converts a high-definition television signal (HDTV signal) to a standard television signal for display on a standard-size television screen. The demand for receivers equipped to make this conversion is expected to be strong while conventional TV and HDTV coexist, as they already do in Japan and soon will in other countries. The conversion can be carried out in several modes, requiring stable clock signals of different frequencies. To give the viewer a choice of modes, it is desirable for a single frequency synthesizer to be able to synthesize all the necessary clock frequencies.

A frequency synthesizer is conventionally configured as a phase-locked loop (PLL) comprising a phase comparator, a loop filter, and a voltage-controlled oscillator (VCO) coupled in series. The phase comparator receives an input signal and the VCO generates an output signal, which is also fed back to the phase comparator. Different output frequencies can be obtained by appropriate division of the input and feedback signals.

It is desirable for a frequency synthesizer to be implemented in an integrated circuit. In one conventional integrated-circuit design, the loop filter is an active low-pass filter employing an operational amplifier, and the VCO is a voltage-controlled multivibrator. In HDTV signal converters, however, frequency synthesizers of this design tend to suffer from output jitter. An active filter employing an operational amplifier, particularly a filter small enough to form part of an integrated circuit, cannot adequately reject all the high frequencies occurring in the output of the phase comparator in different modes. Moreover, a voltage-controlled multivibrator does not possess inherently high frequency stability, so the unrejected high frequencies can easily disturb the output.

This problem can be solved by employing, in place of the multivibrator, an LC oscillator circuit comprising an inductor and a capacitor that resonate at a particular frequency. Different output frequencies are obtained by switching among different capacitors. Unfortunately, although the output is stable, the circuit can no longer be satisfactorily integrated; the inductor, capacitors, and switch must all be external components. The switch is particularly inconvenient because it requires bulky mechanical contacts in order to obtain low on-resistance.

## SUMMARY OF THE INVENTION

It is accordingly an object of the present invention to enable a frequency synthesizer in an integrated circuit to produce jitter-free output signals at a variety of selectable frequencies.

The invented frequency synthesizer comprises a pair of cascaded phase-locked loops. The first phase-locked loop receives an input clock signal and a first feedback signal and generates an internal clock signal. The second phase-locked loop receives the internal clock signal and a second feedback signal and generates an output clock signal. The output clock signal is supplied to both the first and second phase-locked loops for use as the first and second feedback signals. The first phase-locked loop has programmable frequency dividers for dividing the frequencies of the input clock signal and first feedback signal.

## BRIEF DESCRIPTION OF THE DRAWINGS

Fig. 1 is a sketch illustrating different modes for converting an HDTV picture to a standard TV picture.

Fig. 2 is a block diagram of a television signal converter, illustrating a type of circuit in which the invented frequency synthesizer can be advantageously used.

Fig. 3 is a block diagram of the invented frequency synthesizer.

## DETAILED DESCRIPTION OF THE INVENTION

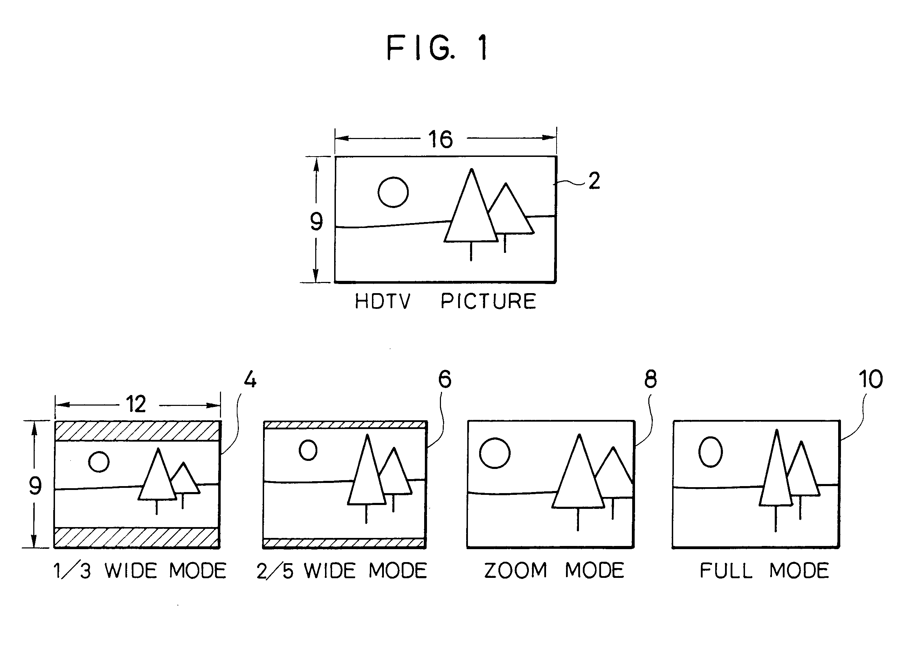

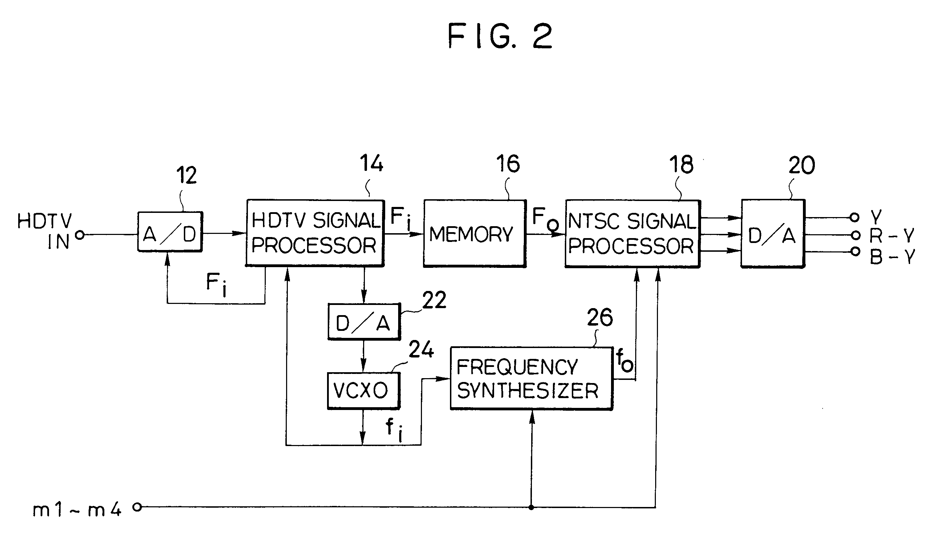

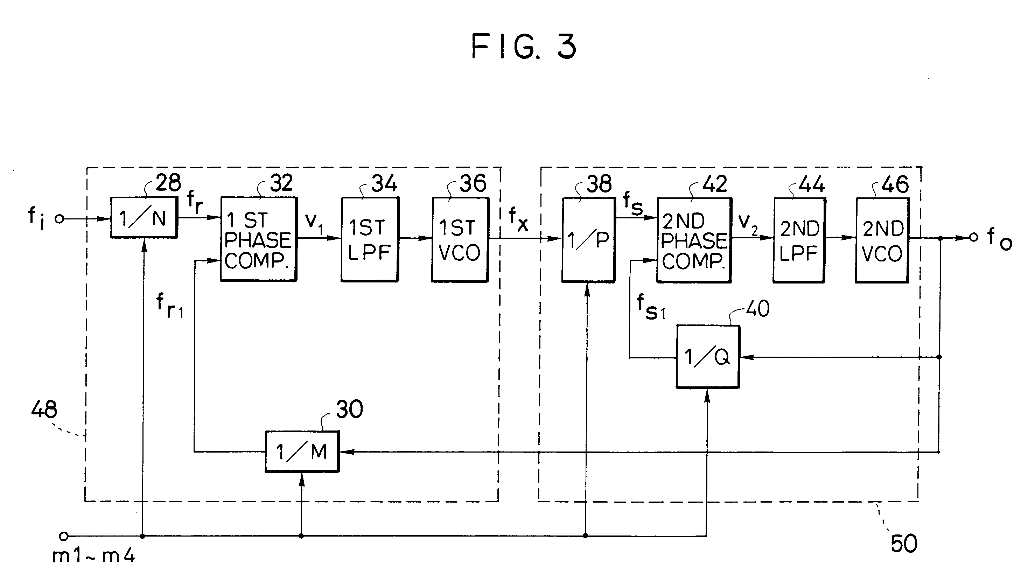

The invention will now be described in more detail with reference to the attached drawings. Figs. 1 and 2 illustrate one of the purposes for which the invention can be used, although applications of the invention are not limited to this purpose. Fig. 3 illustrates an embodiment of the invention, although the scope of the invention, as set forth in the appended claims, is not restricted to this embodiment.

For notational convenience, in the description and drawings, the same symbol (such as $f_i$) will be used to denote both a signal and its frequency.

Fig. 1 shows four modes in which an HDTV picture 2 can be displayed on a conventional television screen. The HDTV picture has a 9:16 aspect ratio with, for example, 1125 horizontal scanning lines, while the conventional screen has a 3:4 (i.e. 9:12) aspect ratio with, for example, 525 scanning lines. In the 1/3 wide mode 4, three HDTV scanning lines are combined into one conventional scanning line. The resulting picture is displayed

2

on a central band of the conventional screen, with substantially the same aspect ratio as the HDTV picture. In the 2/5 wide scanning mode 6, five HDTV scanning lines are combined into two conventional scanning lines. The resulting picture is displayed on a taller central band of the conventional screen, altering the aspect ratio so that objects appear somewhat squeezed horizontally. In zoom mode 8 the right and left side portions of the HDTV picture are discarded to make the picture fit the conventional screen without squeezing. In full mode 10 the entire HDTV picture is displayed on the entire conventional screen, with considerable squeezing.

Table 1 lists parameters of the conventional and HDTV systems employed in Japan. The HDTV system, named MUSE, is an analog system developed by Japan's national broadcasting association (NHK). The conventional system is the well-known NTSC system developed by the National Television System Committee in the United States. Also listed is an extended-definition television (EDTV) system, which is a type of NTSC system that employs progressive scanning instead of interlaced scanning.

Although the HDTV and conventional television systems used in other countries may differ somewhat from the Table 1, modes similar those shown in Fig. 1 will still apply. Applications of the invention are not restricted to any particular television system.

Table 1  Parameters of Conventional and HDTV Systems

|  | HDTV System (MUSE) | NTSC System | |
| --- | --- | --- | --- |
|  |  | Conventional | EDTV |
| Number of scanning lines | 1125 | 525 | 525 |
| Aspect ratio | 16:9 | 4:3 | 4:3 |
| Interlace ratio | 2:1 | 2:1 | 1:1 |
| Field frequency (Hz) | 60 | 59.94 | 59.94 |

Fig. 2 illustrates a picture converter capable of converting an analog HDTV signal such as a MUSE signal to a conventional NTSC signal. The HDTV signal is input to an analog-to-digital (A/D) converter 12, converted to a digital signal, and processed by an HDTV signal processor 14. The resulting data are written into a memory 16 at a clock rate $F_i$. The data are then read from the memory 16 at a different clock rate $F_o$ by an NTSC signal processor 18, and processed to produce a digital luminance signal Y and digital color difference signals R - Y and B - Y. These are converted to analog signals by a digital-to-analog (D/A) converter 20, and supplied to conventional television circuits to create a television picture.

The write clock frequency $F_i$ and read clock frequency $F_o$ are generated from clock signals having twice these frequencies, namely $f_i = 2F_i$ and $f_o = 2F_o$. To produce $f_i$, the HDTV signal processor 14 sends a digital control signal to a D/A converter 22, and the resulting analog control signal is applied to a voltage-controlled crystal oscillator (VCXO) 24. The output of the VCXO 24 is a clock signal with frequency $f_i$. Input to the HDTV signal processor 14, this $f_i$ clock signal generates both the $F_i$ write clock and an $F_i$ sampling clock furnished to the A/D converter 12.

For a MUSE signal, the VCXO 24 is adapted to oscillate at 32.4 MHZ. The HDTV signal processor 14 controls the VCXO 24 by slightly varying the oscillation rate so as to hold $F_i$ at precisely 960/2 times the horizontal scanning frequency, thereby keeping $F_i$ in accurate synchronization with the HDTV input signal. The HDTV horizontal scanning frequency is 33.750 kHz, so $F_i$ is 16.2 MHz.

To produce $f_o$, the $f_i$ clock signal from the VCXO 24 is also input to a frequency synthesizer 26, together with a mode control signal having four states, denoted m1 to m4. The frequency synthesizer 26 generates an output clock signal with a frequency $f_o$ that depends on the mode control signal. Although the $f_i$ and $f_o$ frequencies differ, the frequency synthesizer 26 keeps the $f_i$ input clock and $f_o$ output clock precisely synchronized, so that memory reading and writing will stay in step.

The required output frequency $f_o$ depends on the mode in which the NTSC signal is generated from the HDTV signal. For example, the full mode shown in Fig. 1 requires a higher frequency than the zoom mode, because the latter reads only part of the data in each HDTV scanning line. Table 2 lists the $f_i$ and $f_o$ frequencies for the four modes shown in Fig. 1, assuming the signal parameters in Table 1.

Table 2 Frequency Synthesizer Clock Frequencies

| Mode | Input Clock (MHz) $f_i$ (= $2F_i$) | Output Clock (MHz) $f_o$ (= $2F_o$) | Notes |
|------|------|------|------|
| m1 | 32.4 | 20.16 | Zoom mode |
| m2 | 32.4 | 27.405 | Full mode |
| m3 | 32.4 | 25.2 | 2/5 wide mode |
| m4 | 32.4 | 29.295 | 1/3 wide mode |

Fig. 3 shows the invented frequency synthesizer, which can be advantageously used in Fig. 2 to generate the output clock $f_o$ from the input clock $f_i$ according to the mode control signal.

A first frequency divider 28 divides the input signal $f_i$ by a ratio N to create a signal $f_r$. A second frequency divider 30 divides the output signal $f_o$ by another ratio M to create a feedback signal $f_{r1}$. A first phase comparator 32 receives $f_r$ and $f_{r1}$ and generates a first error voltage $v_1$ responsive to the frequency and phase difference between $f_r$ and $f_{r1}$. A first low-pass filter (LPF) 34 removes high-frequency components from the error voltage $v_1$. The output of the LPF 34 is applied to a first voltaage-controlled oscillator (VCO) 36, which generates an internal clock signal $f_x$. The internal clock frequency $f_x$ is constant, so the first VCO 36 can be an oscillator with high frequency stability, preferably a voltage-controlled crystal oscillator (VCXO).

A third frequency divider 38 divides the internal clock signal $f_x$ by a ratio P to create a signal $f_s$. A fourth frequency divider 40 divides the output signal $f_o$ by another ratio Q to create a feedback signal $f_{s1}$. A second phase comparator 42 receives $f_s$ and $f_{s1}$ and generates a second error voltage $v_2$ responsive to the frequency and phase difference between $f_s$ and $f_{s1}$. A second LPF 44 removes high-frequency components from the error voltage $v_2$. The output of the LPF 44 is applied to a second VCO 46, which generates the output signal $f_o$. The second VCO 46 is, for example, a voltage-controlled multivibrator capable of oscillating at all of the output frequencies $f_o$ listed in Table 1.

The first, second, third, and fourth frequency dividers 28, 30, 38, and 40 are programmable frequency dividers that are controlled by the mode control signal, which takes on values m1, m2, m3, and m4 to select the four modes listed in Table 2. The values of N, M, P, and Q vary depending on the selected mode.

The first and second LPFs 34 and 44 are, for example, low-pass filters of the well-known RC type, comprising resistor-capacitor networks. However, the invention is not limited to the use of RC filters as the low-pass filters 34 and 44. Nor is it limited to the use of a voltage-controlled crystal oscillator as the first VCO 36, or a voltage-controlled multivibrator as the second VCO 46. The invention can obviously be practiced with other types of filters and oscillators.

The circuit in Fig. 3 can be viewed as a pair of cascaded phase-locked loops (PLLs) 48 and 50 in which the output of the second PLL 50 is fed back to both the first and second PLLs. The first PLL 48 comprises the first and second frequency dividers 28 and 30, the first phase comparator 32, the first LPF 34, and the first VCO 36. The second PLL 50 comprises the third and fourth frequency dividers 38 and 40, the second phase comparator 42, the second LPF 44, and the second VCO 46. The second PLL 50 operates so as to lock $f_{s1}$ to $f_s$ in frequency and phase.

Alternatively, the circuit in Fig. 3 can be viewed as a pair of nested PLLs, the inner PLL functioning as the loop filter of the outer PLL. The inner PLL comprises the first LPF 34, the first VCO 36, the third and fourth frequency dividers 38 and 40, the second phase comparator 42, and the second LPF 44. The outer PLL comprises the first and second frequency dividers 28 and 30, the first phase comparator 32, and the second VCO 46. The outer PLL operates so as to lock $f_{r1}$ to $f_r$ in frequency and phase, thereby also keeping $f_o$ accurately synchronized to $f_i$

The first and second frequency dividers 28 and 30 ensure that $f_r = f_i/N$ and $f_{r1} = f_o/M$. In the locked state, since $f_r$ and $f_{r1}$ are equal,

$$f_o = f_i \times (M/N) \quad (1)$$

The third and fourth frequency dividers 38 and 40 ensure that $f_s = f_x/P$ and $f_{s1} + f_o/Q$. In the locked state, since $f_s$ and $f_{s1}$ are equal,

$$f_o = f_x \times Q/P \quad (2)$$

From these equations it follows that

$$f_x = f_i \times M/N \times P/Q \quad (3)$$

Equation (1) can be used to determine suitable integer values for M and N from $f_i$ and $f_o$ in each mode. Equation (2) or (3) can be used to determine integer values for P and Q. $f_x$ has a fixed value equal to the oscillating frequency of the first VCO 36 when the first error voltage $v_1$ is, for example, zero. Table 3 shows a suitable set of values for N, M, P, and Q when $f_x$ is 1.89 MHz. Also shown in Table 3 are the values of $f_i$, $f_o$, $f_r$, and $f_s$. It can be readily verified that these parameters satisfy equations (1) to (3), from which it follows that the frequency synthesizer will lock at the desired output frequency $f_o$ in each mode.

Table 4 Frequency Synthesizer Parameters

| Mode | | m1 | m2 | m3 | m4 |
|---|---|---|---|---|---|
| Division Ration | N | 45 | 240 | 36 | 240 |
| | M | 28 | 203 | 28 | 217 |
| | P | 3 | 2 | 3 | 2 |
| | Q | 32 | 29 | 40 | 31 |
| $f_i$ (MHz) | | 32.4 | 32.4 | 32.4 | 32.4 |
| $f_o$ (MHz) | | 20.16 | 27.405 | 25.2 | 29.295 |
| $f_x$ (MHz) | | 1.89 | 1.89 | 1.89 | 1.89 |
| $f_r$ (MHz) | | 0.72 | 0.135 | 0.9 | 0.135 |
| $f_s$ (MHz) | | 0.53 | 0.945 | 0.63 | 0.945 |
| Notes | | Zomm mode | Full mode | 2/5 wide mode | 1/3 wide mode |

It remains to describe the frequency stability of the circuit in FIG. 3. Instability arises from unwanted high-frequency components in the error voltages $v_1$ and $v_2$ which are inadequately rejected by the LPFs 34 and 44. These unwanted high-frequency componellts comprise mainly the frequencies of the clock and feedback inputs to the phase comparators, and their higher harmonics. Specifically, the high-frequency components present in the first error voltage $v_1$ are $f_r$ and its harmonics, while the high-frequency components present in the second error voltage $v_2$ are $f_s$ and its harmonics. The cutoff frequency of the LPF 34 or 44 is ideally set below the frequencies to be rejected, but not too far below these frequencies, lest it unduly slow the action of the loop.

The first LPF 34 must reject $f_r$ and its harmonics. Referring to Table 3, $f_r$, is 0.135 MHz in modes m2 and m4, 0.72 MHz in mode m1, and 0.9 MHz in mode m3, varying by a factor of more than six. If the cutoff frequency of the first LPF 34 is set high enough for satisfactory operation in modes m1 and m3, the LPF 34 will fail to reject all the high-frequency components occurring in modes m2 and m4. Because of the stability of the first VCO 36, however, the remaining high-frequency components in the first error voltage $v_1$ can be tolerated; the output frequency $f_x$ of the VCO 36 is substantially unaffected by them.

The second LPF 44 must reject $f_s$ and its harmonics. Referring again to Table 3, $f_s$ is 0.63 MHz in modes m1 and m3 and 0.945 MHz in modes m2 and m4, varying by a factor of only one and one-half. The second LPF 44 can be designed to reject both 0.63-MHz and 0.945-MHz components adequately without impairing loop performance. Accordingly, even if the second VCO 46 is not inherently stable, it can produce a jitter-free output frequency $f_o$ because the error voltage $v_2$ is free of high-frequency noise.

All of the circuit blocks shown in Fig. 3 lend themselves to integration. The invented frequency synthesizer can easily be fabricated as an integrated circuit, or as part of an integrated circuit, requiring only a crystal and a few resistors and capacitors as external components. Jitter-free output is obtained without the need for a bulky external mechanical switch.

The invention is of course not limited to the parameters in Table 3. N, M, P, Q, and $f_x$ can be varied according to the requirements of different television systems.

It is even possible to eliminate the third and fourth frequency dividers by setting P and Q to unity in all modes. In that case $f_x$ is no longer constant; it becomes equal to $f_o$, so the first VCO 36 must oscillate at the same frequencies as the second VCO 46. Instead of a voltage-controlled crystal oscillator, a voltage-controlled multivibrator or other type of oscillator must be used for the first VCO 36. Even in this extreme case, the invention succeeds in reducing output jitter. Since $f_s$ also becomes equal to $f_o$, the frequencies to be rejected by the second LPF 44 again vary by a factor of only about one and one-half, and the second LPF 44 can be designed to reject all of them adequately.

Those skilled in the art will realize that further modifications can be made in the circuit shown in Fig. 3

EP 0 585 050 A2

without departing from the scope of the invention as claimed below.

**Claims**

1. A frequency synthesizer, comprising:
   a first phase-locked loop for receiving an input clock signal and a first feedback signal and generating an internal clock signal; and
   a second phase-locked loop coupled to receive said internal clock signal and a second feedback signal, and generate an output clock signal; wherein
   said output clock signal is supplied to both said first phase-locked loop and said second phase-locked loop for use as said first feedback signal and said second feedback signal.

2. The frequency synthesizer of claim 1, wherein said first phase-locked loop has a first programmable frequency divider for dividing said input clock signal.

3. The frequency synthesizer of claim 1, wherein said first phase-locked loop has a second programmable frequency divider for dividing said first feedback signal.

4. The frequency synthesizer of claim 1, wherein said first phase-locked loop has a voltage-controlled crystal oscillator.

5. The frequency synthesizer or claim 1, wherein said second phase-locked loop has a third programmable frequency divider for dividing said internal clock signal.

6. The frequency synthesizer or claim 1, wherein said second phase-locked loop has a fourth programmable frequency divider for dividing said second feedback signal.

7. The frequency synthesizer of claim 1, wherein said second phase-locked loop has a voltage-controlled multivibrator.

8. The frequency synthesizer of claim 1, wherein said first phase-locked loop and said second phase-locked loop are both fabricated in a single integrated circuit.

9. A frequency synthesizer for receiving an input clock signal and a mode control signal, and generating an output clock signal having a frequency responsive to said mode control signal, comprising:
   a first frequency divider for dividing said input clock signal by a factor responsive to said mode control signal;
   a second frequency divider for dividing said output clock signal by a factor responsive to said mode control signal;
   a first phase comparator coupled to compare outputs of said first frequency divider and said second frequency divider and generate a first error voltage;
   a first low-pass filter coupled to remove high-frequency components from said first error voltage;
   a first voltage-controlled oscillator coupled to said first low-pass filter, for generating an internal clock signal with a frequency responsive to said first error voltage;
   a second phase comparator coupled to compare said internal clock signal with said output clock signal and generate a second error voltage;
   a second low-pass filter coupled to remove high-frequency components from said second error voltage; and
   a second voltage-controlled oscillator coupled to said second low-pass filter, for generating said output clock signal at a frequency responsive to said second error voltage.

10. The frequency divider of claim 9, wherein said first low-pass filter is an RC filter.

11. The frequency divider of claim 9, wherein said second low-pass filter is an RC filter.

12. The frequency divider of claim 9, wherein said first voltage-controlled oscillator is a voltage-controlled crystal oscillator.

13. The frequency divider of claim 9, further comprising:

6

a third frequency divider coupled between said first voltage-controlled oscillator and said second phase comparator, for dividing said internal clock signal by a factor responsive to said mode control signal; and

a fourth frequency divider coupled to divide said output clock signal by a factor responsive to said mode control signal prior to input of said output clock signal to said second phase comparator.

# FIG. 1

16

9

2

HDTV PICTURE

12

9

4

1/3 WIDE MODE

6

2/5 WIDE MODE

8

ZOOM MODE

10

FULL MODE

EP 0 585 050 A2

# FIG. 2

EP 0 585 050 A2

# FIG. 3

EP 0 585 050 A2